# EUROPEAN PATENT SPECIFICATION

(11) **EP 2 874 478 B1**
(45) Date of publication and mention of the grant of the patent: **19.04.2017**
(21) Application number: 13193248.5
(22) Date of filing: 18.11.2013
(51) Int. Cl.: H05K 7/14

(54) **Slide rail assembly for rack system**
Gleitschienenanordnung für Regalsystem
Ensemble rail coulissant pour système de crémaillère

(43) Date of publication of application: 20.05.2015
(73) Proprietor: King Slide Works Co., Ltd., Kaohsiung City (TW); King Slide Technology Co., Ltd., Kaohsiung City (TW)
(72) Inventor: Chen, Ken-Ching, Kaohsiung City (TW); Yang, Shun-Ho, Kaohsiung City (TW); Yeh, Chih-Hsin, Kaohsiung City (TW); Wang, Chun-Chiang, Kaohsiung City (TW)
(74) Representative: Viering, Jentschura & Partner mbB Patent- und Rechtsanwälte

(56) References cited:
- EP-A1- 2 517 604
- US-A1- 2011 017 894
- US-A1- 2011 017 895

## Description

### BACKGROUND OF THE INVENTION

### 1. Fields of the invention

The present invention relates to a slide rail assembly for use in a rack system, and more particularly, to a slide rail assembly which has an adjustable length and allows a chassis to move along its adjusted length.

### 2. Descriptions of Related Art

To facilitate the examination and maintenance of rack-type servers in a computer system, the conventional chassis for the rack-type servers usually has slide rails installed on two sides thereof and are connected to posts of a rack by support members which are connected to the slide rails such that the servers can be easily pulled out from the rack.

US Patent No. 7,137,512, 6,574,100, 6,930,886 and 6,948,691 have disclosed related techniques of rack systems and are incorporated herein by reference.

The related prior art usually modularizes different electronic components of a server into different modules, such as to arrange a CPU module, a hard disk module, and a power supply module, etc. in a chassis, and connects those different modules by cables to facilitate the examination and maintenance of the servers. For example, a module, such as the CPU module, can be removed from the chassis after the cables connected between the different modules are removed. However, due to the narrow and limited space of the chassis and the complication of the cables, the removal of the cables is not easy, and this brings a lot of difficulties for the workers.

EP 2 517 604 A1 discloses a positioning mechanism for a quick release device of a slide assembly including an opening in a rail and a positioning member located corresponding to the opening. However, the length of the server chassis is not adjustable so that the examination and maintenance of the server is complicated.

The present invention intends to provide a slide rail assembly for a rack system, wherein the length of the slide rail assembly is adjustable such that the installation or removal of the cables of the servers is facilitated.

### SUMMARY OF THE INVENTION

The present invention relates to a slide rail assembly, comprising: an outer rail and an inner rail. The inner rail longitudinally movable relative to the outer rail and has a top wall, a bottom wall and a side wall. The side wall is connected between the top and bottom walls. The side wall of the inner rail has at least one fixing portion and at least one sliding portion. The at least one fixing portion comprises a first installation hole and a retaining hole. The first installation hole communicates with the retaining hole and has a diameter larger than a diameter of the retaining hole. The at least one sliding portion comprises a second installation hole and a slot. The second installation hole communicates with the slot and has a diameter larger than a width of the slot.

Preferably, the slide rail assembly further comprises a first positioning member connected to the side wall of the inner rail. The first positioning member
has a resilient section and a contact portion. The resilient section is connected to the contact portion, and the contact portion covers up the first installation hole of the at least one fixing portion.

Preferably, a length of the slot is longer than a length of the retaining hole.

Preferably, the outer rail has a top plate, a bottom plate and a side plate. The side plate is connected between the top plate and the bottom plate.

Preferably, the slide rail assembly comprises a middle rail movably connected between the outer and inner rails such that the inner rail is allowed to move away from the outer rail in cooperation with the relative movement between the middle rail and the outer rail.

Preferably, the slide rail assembly is adapted to be installed to a chassis. The chassis comprises a first chassis and a second chassis. The first chassis has a retaining member. The second chassis has a sliding member. The retaining member of the first chassis is allowed to be inserted in the at least one fixing portion via the first installation hole and be further shifted to the retaining hole, and the sliding member of the second chassis is allowed to be inserted in the at least one sliding portion via the second installation hole and be further shifted to the slot.

Preferably, the slide rail assembly further comprises a first positioning member connected to the side wall of the inner rail and located corresponding to the at least one fixing portion of the inner rail. The first positioning member is used to prevent the retaining member from being pulled out from the at least one fixing portion via the first installation hole.

Preferably, the slide rail assembly further comprises a first positioning member connected to the side wall of the inner rail. The first positioning member has a resilient section and a contact portion. The contact portion is connected to the resilient section and covers up the first installation hole of the at least one fixing portion.

Preferably, the slide rail assembly further comprises a second positioning member connected to the side wall of the inner rail. The second positioning member covers up the second installation hole of the at least one sliding portion.

The present invention also provides a rack system having a slide rail assembly, comprising: a rack having a first post, a second post, a third post and a fourth post, wherein the slide rail assembly is connected between the first and second posts; and a second slide rail assembly connected between the third and fourth posts. The rack system further comprises a chassis connected between the slide rail assembly and the second slide rail assembly. The chassis comprises a first chassis and a second chassis. The first chassis is connected to the at least one fixing portion of the inner rail by a retaining member, and the second chassis is movably connected to the at least one sliding portion of the inner rail by a sliding member such that the second chassis is allowed to slide toward or away from the first chassis.

Preferably, the rack system as further comprises a first positioning member connected to the inner rail. The first positioning member has a resilient section and a contact portion. The contact portion is connected to the resilient section and covers up the first installation hole of the at least one fixing portion.

Preferably, the at least one sliding portion has a stop portion. The stop portion contacts and stops the at least one sliding member when the second chassis slides away from the first chassis to reach a maximum extended position.

The present invention will become more obvious from the following description when taken in connection with the accompanying drawings which show, for purposes of illustration only, a preferred embodiment in accordance with the present invention.

### BRIEF DESCRIPTION OF THE DRAWINGS

FIG. 1 is a schematic view of a rack system in accordance with a preferred embodiment of the present invention;
FIG. 2A is a exploded view of a inner rail and a chassis;
FIG. 2B is an enlarged view of a fixing portion of the inner rail shown in FIG. 2A;
FIG. 2C is an enlarged view of a sliding portion of the inner rail shown in FIG. 2A;
FIG. 3 is a schematic view of the rack system, wherein the inner rail is installed to the chassis;
FIG. 4 is a side view of the rack system, wherein the chassis is installed to the rack;
FIG. 5 is a side view of the rack system, wherein a second chassis of the chassis is pulled away from a first chassis of the chassis, and
FIG. 6 is a perspective view of the rack system, wherein the second chassis of the chassis is pulled away from the first chassis of the chassis.

### DETAILED DESCRIPTION OF THE PREFERRED EMBODIMENT

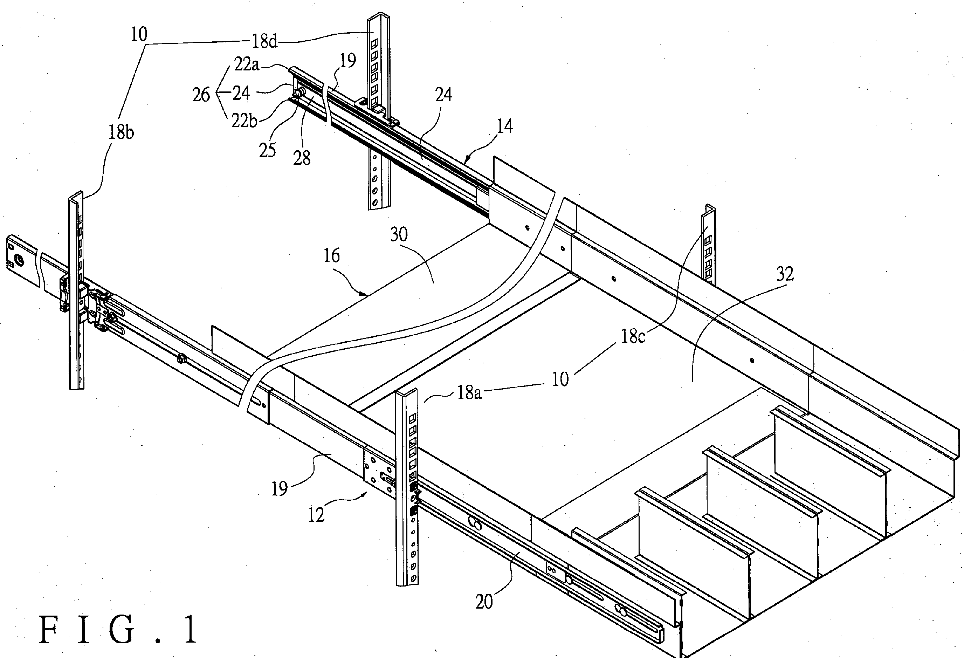

FIG.1 shows a preferred embodiment of the present invention, which comprises a rack 10, a first slide rail assembly 12, a second slide rail assembly 14 and a chassis 16. The rack 10 comprises a first post 18a, a second post 18b, a third post 18c and a fourth post 18d. The first slide rail assembly 12 is connected between the first and second posts 18a, 18b. The second slide rail assembly 14 is connected between the third and fourth posts 18c, 18d. The chassis 16 is connected between the first and second slide rail assemblies 12, 14.

The first slide rail assembly 12 and the second slide rail assembly 14 are disposed symmetrically, and at least one of the first slide rail assembly 12 and the second slide rail assembly 14 has an outer rail 19 and an inner rail 20, wherein the inner rail 20 is longitudinally movable relative to the outer rail 19. Specifically, the outer rail 19 has a top plate 22a, a bottom plate 22b and a side plate 24, wherein the side plate 24 is connected between the top plate 22a and the bottom plate 22b. The top plate 22a, the bottom plate 22b and the side plate 24 of the outer rail 19 form a longitudinal passage 26, and the inner rail 20 is configured to move along the longitudinal passage 26 of the outer rail 19 such that the inner rail 20 is able to be pushed or pulled to move toward or away from the outer rail 19.

Preferably, the present invention further comprises a middle rail 28. The middle rail 28 is movably connected between the outer and inner rails 19, 20 such that the inner rail 20 is able to be pulled to move further away from the outer rail 19 in cooperation with the relative movement between the middle rail 28 and the outer rail 19. In additional, the distance that the inner rail 20 is able to move relative to the outer rail 19 can be adjusted according to needs. For example, in one embodiment, the middle rail 28 is fixed to the outer rail 19 by a bar 25, a pin, a cotter, or the like such that the middle rail 28 is unable to move relative to the outer rail 19, and thus only the inner rail 20 is pulled out when a pull force is applied to the end of the inner rail 20.

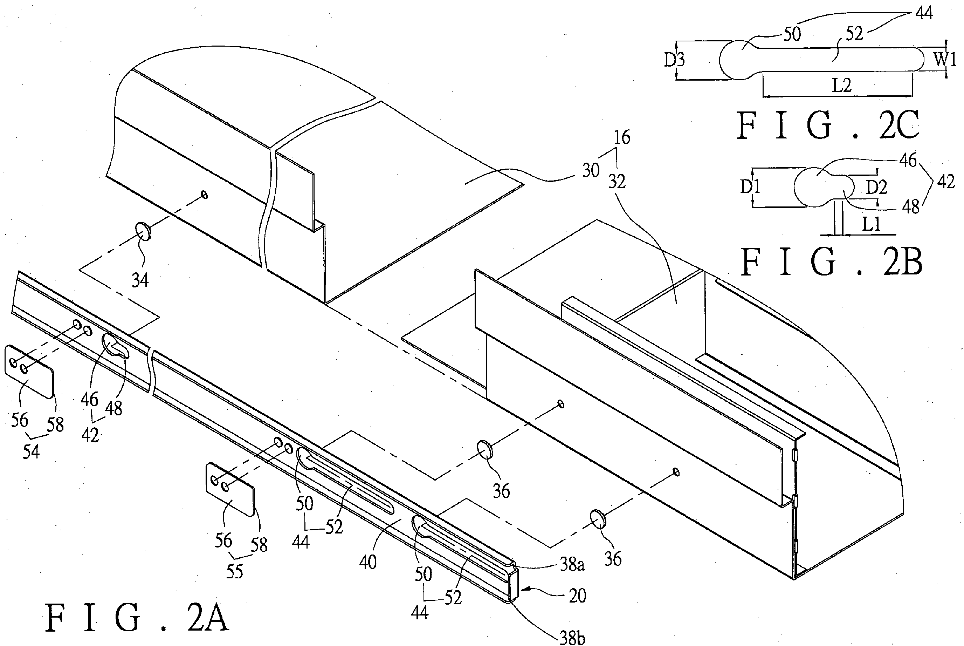

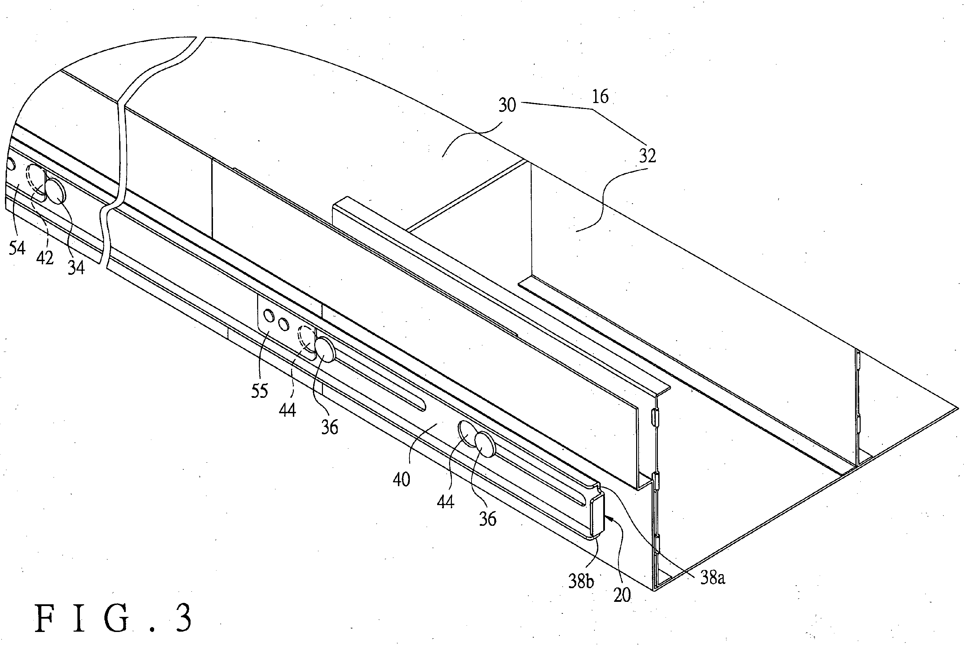

Furthermore, as shown in FIGS. 2A and 3, the chassis 16 comprises a first chassis 30 and a second chassis 32. At least one retaining member 34 is connected to a side of the first chassis 30, and at least one sliding member 36 is connected to a side of the second chassis 32. Wherein, the first chassis 30 is connected to the inner rail 20 by the at least one retaining member 34, and the second chassis 32 is movably connected to the inner rail 20 by the at last one sliding member 36.

The inner rail 20 further comprises a top wall 38a, a bottom wall 38b and a side wall 40, wherein the side wall 40 is connected between the top and bottom walls 38a, 38b. The side wall 40 of the inner rail 20 has at least one fixing portion 42 and at least one sliding portion 44. The at least one fixing portion 42 comprises a first installation hole 46 and a retaining hole 48. The first installation hole 46 communicates with the retaining hole 48, as shown in FIGS. 2B, and has a diameter D1 larger than a diameter D2 of the retaining hole 48 such that the at least one retaining member 34 is allowed to be inserted in or pulled out from the at least one fixing portion 42 via the first installation hole 46 although the at least one retaining member 34 is not allowed to be inserted in or pulled out from the at least one fixing portion 42 via the retaining hole 48. The at least one sliding portion 44 comprises a second installation hole 50 and a slot 52. The second installation hole 50 communicates with the slot 52, as shown in FIG. 2C, and has a diameter D3 larger than a width W1 of the slot 52 such that the at least one sliding member 36 is allowed to be inserted in or pulled out from the at least one sliding portion 44 via the second installation hole 50 although the at least one sliding member 36 is not allowed to be inserted in or pulled out from the at least one sliding portion 44 via the slot 52. It is should be noted that a length L2 of the slot 52 is longer than a length L1 of the retaining hole 48.

More specifically, when the at least one retaining member 34 is inserted through the first installation hole 46 and further shifted to the retaining hole 48, the first chassis 30 is installed to the inner rail 20. When the at least one sliding member 36 is inserted through the second installation hole 50 and further shifted to the slot 52, the second chassis 32 is installed to the inner rail 20.

In one preferred embodiment, a first positioning member 54 and a second positioning member 55 are connected to the inner rail 20, wherein the first positioning member 54 is located corresponding to the at least one fixing portion 42 of the inner rail 20, and the second positioning member 55 is located corresponding to the at least one sliding portion 44 of the inner rail 20.

The first positioning member 54 comprises a resilient section 56 and a contact portion 58, wherein the contact portion 58 is connected to the resilient section 56. Preferably, the contact portion 58 extends from the resilient section 56 and is configured to cover up the first installation hole 46 to prevent the at least one retaining member 34 of the first chassis 30 from being pulled out from the first installation hole 46 when the first chassis 30 is installed to the inner rail 20. More specifically, when installation, the at least one retaining member 34 of the first chassis 30 is inserted through the first installation hole 46 to prop up the first positioning member 54 until the at least one retaining member 34 is further shifted to the retaining hole 48. Thereby, after the at least one retaining member 34 is further shifted to the retaining hole 48, the first positioning member 54 is recovered to cover up the first installation hole 46 by the elastic recovery force of the resilient section 56 such that the at least one retaining member 34 is kept in the retaining hole 48 and is not allowed to be shifted back to the first installation hole 46, and the inner rail 20 is therefore securely installed to the first chassis 30. In contrast, when removing the inner rail 20 from the first chassis 30, a user has to pull the first positioning member 54 outwardly from the inner rail 20 and shift the at least one retaining member 34 of the first chassis 30 back to the first installation hole 46 at the same time such that the at least one retaining member 34 is allowed to be pull out from the first installation hole 46, and the inner rail 20 is therefore removed from the first chassis 30.

Similarly, the second positioning member 55 is configured to prevent the at least one sliding member 36 from being pulled out from the second installation hole 50 when the second chassis 32 is installed to the inner rail 20. As the configuration of the second positioning member 55 is similar to that of the first positioning member 54, the related description is omitted herein.

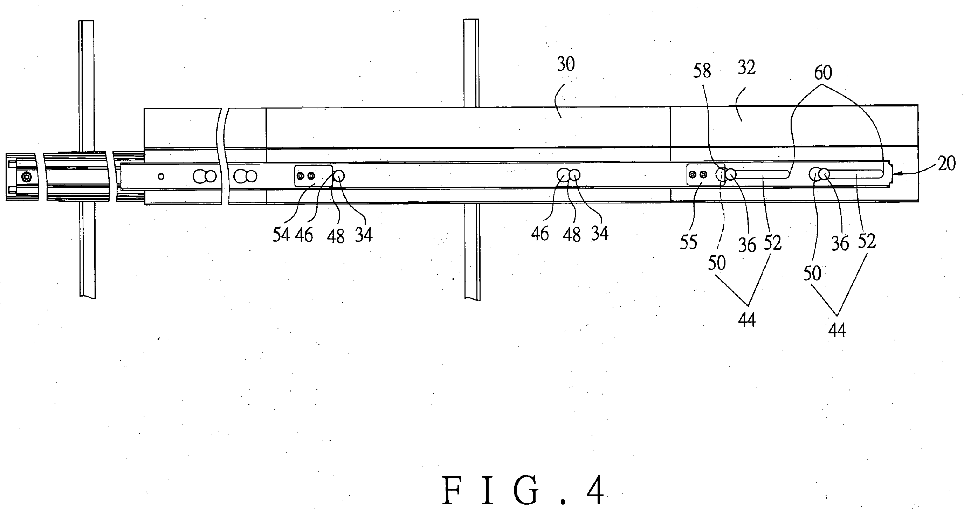

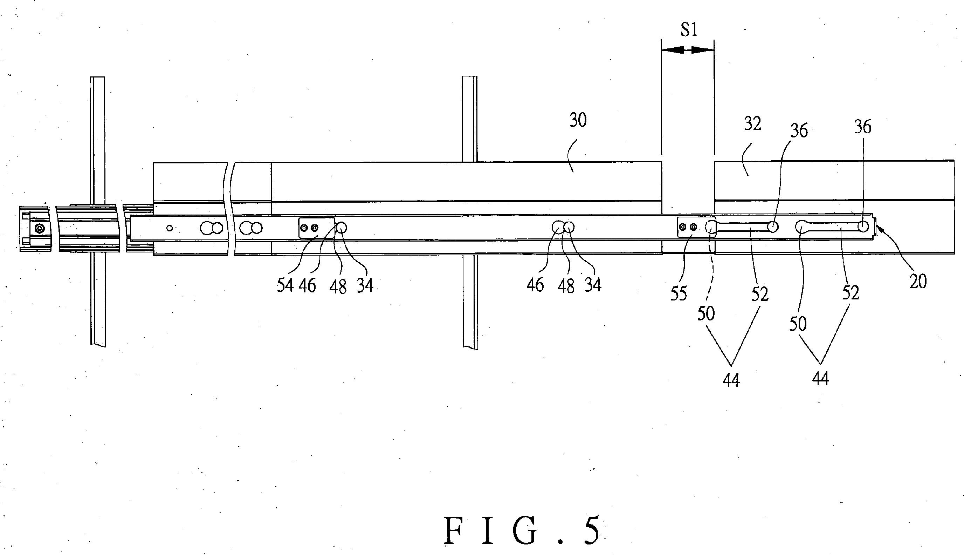

FIGS. 4 and 5 show that the first positioning member 54 covers up the first installation hole 46 upon the at least one retaining member 34 of the first chassis 30 is shifted to the retaining hole 48 such that the at least one retaining member 34 is kept in the retaining hole 48 and is not allowed to be shifted back to the first installation hole 46, and thereby the first chassis 30 is fixed to the inner rail 20.

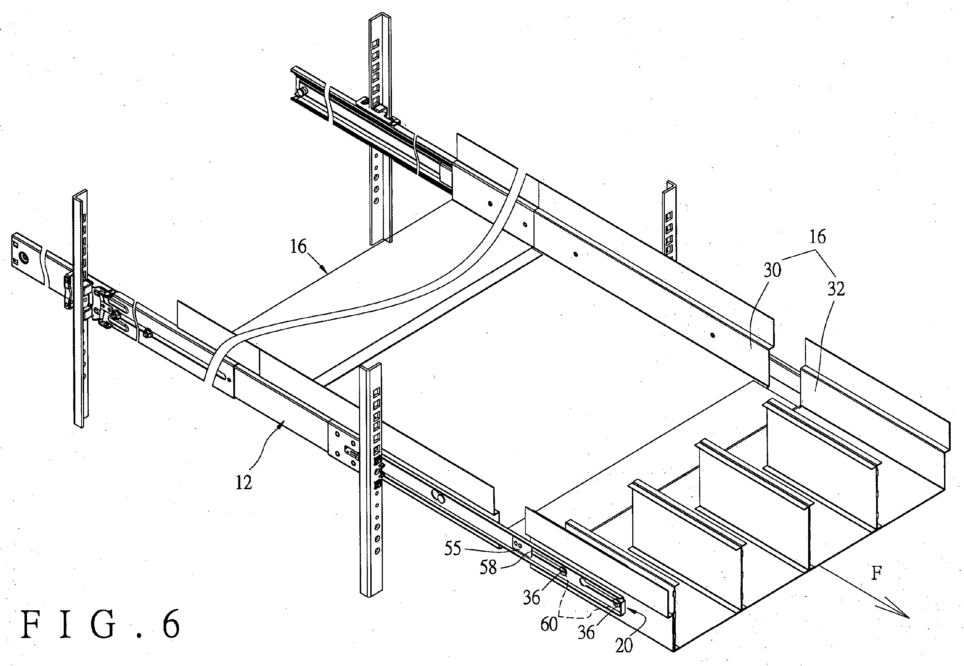

FIGS. 4 and 5 also show that the second positioning member 55 covers up the second installation hole 50 upon the at least one sliding member 36 of the second chassis 32 is shifted to the slot 52 such that the at least one sliding member 36 is kept in the slot 52 and is not allowed to be shifted back to the second installation hole 50, and thereby the at least one sliding member 36 is limited to move in the slot 52 within a distance S1 (as shown in FIG. 5). Furthermore, referring to FIG. 6, when the second chassis 32 is moved away from the first chassis 30 by a force F applied to the second chassis 32 and reaches a maximum extended position (as shown in FIG. 6), the at least one sliding member 36 contacts and is stopped by a stop portion 60 of the sliding portion 44. On the contrary, when the second chassis 32 is moved toward the first chassis 30 and reaches a minimum extended position (as shown in FIG. 4), the at least one sliding member 36 contacts and is stopped by the contact portion 58 of the second positioning member 55.

The present invention provides an extra function of the inner rail 20 by the at least one sliding member 36, which is inserted through the at least one sliding portion 44 of the inner rail 20, and provides a sufficient space for removing the cables which are connected between different modules as well.

While we have shown and described the embodiment in accordance with the present invention, it should be clear to those skilled in the art that further embodiments may be made without departing from the scope of the present invention.

## Claims

1. A slide rail assembly (12) to install a first and a second chassis (30, 32) in a rack system, comprising:
an outer rail (19); and
an inner rail (20) longitudinally movable relative to the outer rail (19),
the inner rail (20) having a top wall (38a), a bottom wall (38b) and a side wall (40), the side wall (40) connected between the top and bottom walls (38a, 38b),
wherein the side wall (40) of the inner rail (20) has at least one fixing portion (42) for the first chassis (30) and at least one sliding portion (44) for the second chassis (32),
wherein the at least one fixing portion (42) comprising a first installation hole (46) and a retaining hole (48), the first installation hole (46) communicating with the retaining hole (48) and having a diameter (D1) larger than a diameter (D2) of the retaining hole (48), and
the at least one sliding portion (44) comprising a second installation hole (50) and a slot (52), the second installation hole (50) communicating with the slot (52) and having a diameter (D3) larger than a width (W1) of the slot (52) such that the second chassis (32) is allowed to slide toward or away from the first chassis (30).

2. The slide rail assembly as claimed in claim 1, further comprising a first positioning member (54) connected to the side wall (40) of the inner rail (20), the first positioning member (54) having a resilient section (56) and a contact portion (58), wherein the resilient section (56) is connected to the contact portion (58), and the contact portion (58) covers up the first installation hole (46) of the at least one fixing portion (42).

3. The slide rail assembly as claimed in claim 1, wherein a length (L2) of the slot (52) is longer than a length (L1) of the retaining hole (48).

4. The slide rail assembly as claimed in claim 1, wherein the outer rail (19) has a top plate (22a), a bottom plate (22b) and a side plate (24), the side plate (24) connected between the top plate (22a) and the bottom plate (22b).

5. The slide rail assembly as claimed in claim 1, further comprising a middle rail (28) movably connected between the outer and inner rails (19, 20) such that the inner rail (20) is allowed to move away from the outer rail (19) in cooperation with the relative movement between the middle rail (28) and the outer rail (19).

6. The slide rail assembly as claimed in claim 1, wherein the slide rail assembly (20) is adapted to be installed to a chassis (16), the chassis (16) comprising a first chassis (30) and a second chassis (32), the first chassis (30) having a retaining member (34), the second chassis (32) having a sliding member (36), and wherein the retaining member (34) of the first chassis (30) is allowed to be inserted in the at least one fixing portion (42) via the first installation hole (46) and be further shifted to the retaining hole (48), and the sliding member (36) of the second chassis (32) is allowed to be inserted in the at least one sliding portion (44) via the second installation hole (50) and be further shifted to the slot (52).

7. The slide rail assembly as claimed in claim 6, further comprising a first positioning member (54) connected to the side wall (40) of the inner rail (20) and located corresponding to the at least one fixing portion (42) of the inner rail (20), wherein the first positioning member (54) is used to prevent the retaining member (34) from being pulled out from the at least one fixing portion (42) via the first installation hole (46).

8. The slide rail assembly as claimed in claim 6, further comprising a first positioning member (54) connected to the side wall (40) of the inner rail (20), wherein the first positioning member (54) has a resilient section (56) and a contact portion (58), the contact portion (58) connected to the resilient section (56) and covering up the first installation hole (46) of the at least one fixing portion (42).

9. The slide rail assembly as claimed in claim 8, further comprising a second positioning member (55) connected to the side wall (40) of the inner rail (20), wherein the second positioning member (55) covers up the second installation hole (50) of the at least one sliding portion (44).

10. A rack system having a slide rail assembly (12) as claimed in claim 1, comprising:
a rack (10) having a first post (18a), a second post (18b), a third post (18c) and a fourth post (18d), wherein the slide rail assembly (12) is connected between the first and second posts (18a, 18b); and
a second slide rail assembly (14) connected between the third and fourth posts (18c, 18d);
being **characterized in that** the rack system comprises a chassis (16) connected between the slide rail assembly (12) and the second slide rail assembly (14), the chassis (16) comprising a first chassis (30) and a second chassis (32), the first chassis (30) connected to the at least one fixing portion (42) of the inner rail (20) by a retaining member (34), the second chassis (32) movably connected to the at least one sliding portion (44) of the inner rail (20) by a sliding member (36) such that the second chassis (32) is allowed to slide toward or away from the first chassis (30).

11. The rack system as claimed in claim 10, further comprising a first positioning member (54) connected to the inner rail (20), the first positioning member (54) having a resilient section (56) and a contact portion (58), the contact portion (58) connected to the resilient section (56) and covering up the first installation hole (46) of the at least one fixing portion (42).

12. The rack system as claimed in claim 10, wherein the at least one sliding portion (44) has a stop portion (60), and the stop portion (60) contacts and stops the at least one sliding member (36) when the second chassis (32) slides away from the first chassis (30) to reach a maximum extended position.

## Patentansprüche

1. Eine Laufschiene (12), bei der ein erstes und zweites Fahrwerk (30, 32)
in ein Regalsystem montiert werden, umfassend:
eine äußere Schiene (19); und
eine innere Schiene (20), die längsbeweglich an der äußeren Schiene (19) montiert ist,
die innere Schiene (20) mit einer oberen Wand (38a), einer unteren Wand (38b) und mit einer Seitenwand (40) montiert ist, wobei die Seitenwand (40) zwischen den oberen und unteren Wänden (38a, 38b) gebildet ist,
wobei die Seitenwand (40) der inneren Schiene (20) mindestens ein Befestigungsteil (42) für das erste Fahrwerk (30) und mindestens ein gleitbares Teil (44) für das zweite Fahrwerk (32) aufweist,
wobei der mindestens eine Befestigungsteil (42) ein erstes Installationsloch (46) und ein Befestigungsloch (48) aufweist; das erste Installationsloch (46) mit dem Befestigungsloch (48) verbunden ist und einen Durchmesser (D1) aufweist, der größer als der Durchmesser (D2) des Befestigungslochs (48) ist, und
der mindestens eine gleitbare Teil (44) ein zweites Installationsloch (50) und eine Schlitzöffnung (52) aufweist; das zweite Installationsloch (50) mit der Schlitzöffnung (52) verbunden ist und einen Durchmesser (D3) aufweist, der größer als eine Breite (W1) der Schlitzöffnung (52) ist, so dass das zweite Fahrwerk (32) auf das erste Fahrwerk (30) zu oder von diesem weggleiten kann.

2. Die Laufschiene nach Anspruch 1, weiter umfassend ein erstes Positionierglied (54), das an der Seitenwand (40) der inneren Schiene (20) befestigt ist; das erste Positionierglied (54) einen federnden Teil (56) und einen Kontaktteil (58) aufweist; wobei der federnde Teil (56) am Kontaktteil (58) befestigt ist und mit diesem Kontaktteil (58) das erste Installationsloch (46) des mindestens einen Befestigungsteils (42) abgedeckt wird.

3. Die Laufschiene nach Anspruch 1, wobei eine Länge (L2) der Schlitzöffnung (52) größer als eine Länge (L1) des Befestigungslochs (48) ist.

4. Die Laufschiene nach Anspruch 1, wobei die äußere Schiene (19) ein oberes Plättchen (22a), ein unteres Plättchen (22b) und ein Seitenplättchen (24) aufweist und dieses Seitenplättchen (24) dabei zwischen dem oberen Plättchen (22a) und dem unteren Plättchen (22b) befestigt ist.

5. Die Laufschiene nach Anspruch 1, weiter umfassend eine mittlere Schiene (28), die beweglich zwischen den äußeren und inneren Schienen (19, 20) so befestigt ist, dass die innere Schiene (20) durch die relative Bewegung zwischen der mittleren Schiene (28) und der äußeren Schiene (19) von der äußeren Schiene (19) wegbewegt werden kann.

6. Die Laufschiene nach Anspruch 1, wobei die Laufschiene (20) an ein Fahrwerk (16) installiert werden kann; das Fahrwerk (16) ein erstes Fahrwerk (30) und ein zweites Fahrwerk (32) umfaßt; das erste Fahrwerk (30) ein Sicherungsglied (34) und das zweite Fahrwerk (32) ein gleitbares Glied (36) aufweist; wobei das Sicherungsglied (34) des ersten Fahrwerks (30) durch das erste Installationsloch (46) in das mindestens eine Befestigungselement (42) eingesetzt und weiter zum Befestigungsloch (48) verschoben werden kann; das gleitbare Glied (36) des zweiten Fahrwerks (32) durch das zweite Installationsloch (50) in den mindestens einen gleitbaren Teil (44) eingesetzt und weiter zur Schlitzöffnung (52) verschoben werden kann.

7. Die Laufschiene nach Anspruch 6, weiter umfassend ein erstes Positionierglied (54), das an der Seitenwand (40) der inneren Schiene (20) befestigt und entsprechend dem mindestens einen Befestigungsteil (42) der inneren Schiene (20) angeordnet ist, wobei mit dem ersten Positionierglied (54) verhindert wird, dass das Sicherungsglied (34) durch das erste Installationsloch (46) aus dem mindestens einen Befestigungsteil (42) herausgezogen werden kann.

8. Die Laufschiene nach Anspruch 6, weiter umfassend ein erstes Positionierglied (54), das an der Seitenwand (40) der inneren Schiene (20) befestigt ist; das erste Positionierglied (54) einen federnden Teil (56) und einen Kontaktteil (58) aufweist; der Kontaktteil (58) am federnden Teil (56) befestigt ist und das erste Installationsloch (46) des mindestens einen Befestigungsteils (42) abdeckt.

9. Die Laufschiene nach Anspruch 8, weiter umfassend ein zweites Positionierglied (55), das an der Seitenwand (40) der inneren Schiene (20) befestigt ist, wobei das zweite Installationsloch (50) des mindestens einen gleitbaren Teils (44) mit dem zweiten Positionierglied (55) abgedeckt wird.

10. Ein Regalsystem mit einer Laufschiene (12) nach Anspruch 1, umfassend:
ein Regal (10) mit einer ersten Stange (18a), zweiten Stange (18b), dritten Stange (18c) und mit einer vierten Stange (18d), wobei die Laufschiene (12) zwischen den ersten und zweiten Stangen (18a, 18b) befestigt ist; und
eine zweite Laufschiene (14), die zwischen den dritten und vierten Stangen (18c, 18d) befestigt ist; **dadurch gekennzeichnet, dass** das Regalsystem ein Fahrwerk (16) umfaßt, das zwischen der Laufschiene (12) und der zweiten Laufschiene (14) befestigt ist; das Fahrwerk (16) ein erstes Fahrwerk (30) und ein zweites Fahrwerk (32) umfaßt; das erste Fahrwerk (30) mit einem Sicherungsglied (34) am mindestens einen Befestigungselement (42) der inneren Schiene (20) befestigt ist; das zweite Fahrwerk (32) mit einem gleitbaren Glied (36) beweglich am mindestens einen gleitbaren Teil (44) der inneren Schiene (20) befestigt ist, so dass das zweite Glied (32) auf das erste Fahrwerk (30) zu oder von diesem weg gleiten kann.

11. Das Regalsystem nach Anspruch 10, weiter umfassend ein erstes Positionierglied (54), das an der inneren Schiene (20) befestigt ist; das erste Positionierglied (54) einen federnden Teil (56) und einen Kontaktteil (58) aufweist; der Kontaktteil (58) am federnden Teil (56) befestigt ist und das erste Installationsloch (46) des mindestens einen Befestigungselements (42) abdeckt.

12. Das Regalsystem nach Anspruch 10, wobei der mindestens eine gleitbare Teil (44) einen Anschlagteil (60) aufweist; der Anschlagteil (60) mit dem gleitbaren Glied (36) in Berührung kommt und dieses anschlägt, wenn das zweite Fahrwerk (32) vom ersten Fahrwerk (30) weggleitet, um eine maximal ausgestreckte Position zu erreichen.

## Revendications

1. Ensemble de glissières (12) pour installer un premier et un second châssis (30, 32) dans un système de bâti, **caractérisée par le fait qu'**elle comprend :
un rail extérieur (19) ; et
un rail intérieur (20) mobile de manière longitudinale par rapport au rail extérieur (19),
le rail intérieur (20) présentant une paroi supérieure (38a), une paroi inférieure (38b) et une paroi latérale (40), la paroi latérale (40) installée entre les parois supérieure et inférieure (38a, 38b),
la paroi latérale (40) du rail intérieur (20) présente au moins une partie d'attache (42) pour le premier châssis (30) et au moins une partie coulissante (44) pour le second châssis (32),
la ou les parties d'attache (42) comprenant un premier orifice d'installation (46) et un orifice de maintien (48), le premier orifice d'installation (46) communiquant avec l'orifice de maintien (48) et présentant un diamètre (D1) supérieur à un diamètre (D2) de l'orifice de maintien (48), et
la ou les parties coulissantes (44) comprenant un second orifice d'installation (50) et une rainure (52), le second orifice d'installation (50) communiquant avec la rainure (52) et présentant un diamètre (D3) supérieur à une largeur (W1) de la rainure (52) de sorte que le second châssis (32) peut s'approcher ou s'écarter en coulissant du premier châssis (30).

2. Ensemble de glissières selon la revendication 1, **caractérisée par le fait qu'**elle comprend en outre un premier élément de positionnement (54) associé à la paroi latérale (40) du rail intérieur (20), le premier élément de positionnement (54) présentant une section résiliente (56) et une partie de contact (58), la section résiliente (56) est associée à la partie de contact (58), et la partie de contact (58) recouvre le premier orifice d'installation (46) de la ou des parties d'attache (42).

3. Ensemble de glissières selon la revendication 1, **caractérisée par le fait que** une longueur (L2) de la rainure (52) est supérieure à une longueur (L1) de l'orifice de maintien (48).

4. Ensemble de glissières selon la revendication 1, **caractérisée par le fait que** le rail extérieur (19) présente une plaque supérieure (22a), une plaque inférieure (22b) et une plaque latérale (24), la plaque latérale (24) montée entre la plaque supérieure (22a) et la plaque inférieure (22b).

5. Ensemble de glissières selon la revendication 1, **caractérisée par le fait qu'**elle comprend en outre un rail intermédiaire (28) monté de manière mobile entre les rails extérieur et intérieur (19, 20) de sorte que le rail intérieur (20) peut s'écarter du rail extérieur (19) en coopération avec le déplacement relatif entre le rail intermédiaire (28) et le rail extérieur (19).

6. Ensemble de glissières selon la revendication 1, **caractérisée par le fait que** l'ensemble de glissières (20) est adapté pour être installé sur un châssis (16), le châssis (16) comprenant un premier châssis (30) et un second châssis (32), le premier châssis (30) présentant un élément de maintien (34), le second châssis (32) présentant un élément coulissant (36), et l'élément de maintien (34) du premier châssis (30) peut être inséré dans la ou les parties d'attache (42) via le premier orifice d'installation (46) et être en outre décalé vers l'orifice de maintien (48), et l'élément coulissant (36) du second châssis (32) peut être inséré dans la ou les parties coulissantes (44) via le second orifice d'installation (50) et être en outre décalé vers la rainure (52).

7. Ensemble de glissières selon la revendication 6, **caractérisée par le fait qu'**elle comprend en outre un premier élément de positionnement (54) associé à la paroi latérale (40) du rail intérieur (20) et situé en correspondance avec la ou les parties d'attache (42) du rail intérieur (20), le premier élément de positionnement (54) est utilisé pour empêcher l'élément de maintien (34) d'être retiré de la ou des parties d'attache (42) via le premier orifice d'installation (46).

8. Ensemble de glissières selon la revendication 6, **caractérisée par le fait qu'**elle comprend en outre un premier élément de positionnement (54) associé à la paroi latérale (40) du rail intérieur (20), le premier élément de positionnement (54) présente une section résiliente (56) et une partie de contact (58), la partie de contact (58) associée à la section résiliente (56) et recouvrant le premier orifice d'installation (46) de la ou des parties d'attache (42).

9. Ensemble de glissières selon la revendication 8, **caractérisée par le fait qu'**elle comprend en outre un second élément de positionnement (55) associé à la paroi latérale (40) du rail intérieur (20), le second élément de positionnement (55) recouvre le second orifice d'installation (50) de la ou des parties coulissantes (44).

10. Un système de bâti présentant un ensemble de glissières (12) selon la revendication 1, **caractérisée par le fait qu'**elle comprend :
un bâti (10) présentant un premier montant (18a), un deuxième montant (18b), un troisième montant (18c) et un quatrième montant (18d), l'ensemble de glissières (12) est monté entre les premier et deuxième montants (18a, 18b) ; et
un second ensemble de glissières (14) monté entre les troisième et quatrième montants (18c, 18d) ; **caractérisé en ce que** le système de bâti comprend un châssis (16) monté entre l'ensemble de glissières (12) et le second ensemble de glissières (14), le châssis (16) comprenant un premier châssis (30) et un second châssis (32), le premier châssis (30) associé à la ou aux parties d'attache (42) du rail intérieur (20) par un élément de maintien (34), le second châssis (32) associé de manière mobile à la ou aux parties coulissantes (44) du rail intérieur (20) par un élément coulissant (36) de sorte que le second châssis (32) peut s'approcher ou s'écarter en coulissant du premier châssis (30).

11. Le système de bâti selon la revendication 10, **caractérisée par le fait qu'**elle comprend en outre un premier élément de positionnement (54) associé au rail intérieur (20), le premier élément de positionnement (54) présentant une section résiliente (56) et une partie de contact (58), la partie de contact (58) associée à la section résiliente (56) et recouvrant le premier orifice d'installation (46) de la ou des parties d'attache (42).

12. Le système de bâti selon la revendication 10, **caractérisée par le fait que** la ou les parties coulissantes (44) présentent une partie de butée (60), et la partie de butée (60) est en contact et arrête le ou les éléments coulissants (36) lorsque le second châssis (32) coulisse à l'écart du premier châssis (30) pour atteindre une position déployée maximale.
